# EUROPEAN PATENT APPLICATION

(11) **EP 2 017 897 A1**
(43) Date of publication of application: **21.01.2009**
(21) Application number: 07013918.3
(22) Date of filing: 16.07.2007
(51) Int. Cl.: H01L 33/00

(54) **Package structure for a high-luminance light source**

(71) Applicant: ILED Photoelectronics Inc., Wugu Township Taipei County 24891 (TW)
(72) Inventor: Chen, Pi-Hsiang, Wugu Township Taipei County 24891 (TW)
(74) Representative: Heyer, Volker

(57) **Abstract**

A package structure for a high-luminance light source comprises a circuit board (20), at least one light source (40) and a resin coating (50) covering the light source (40). A metallic layer (30) is formed on a surface of the circuit board (20) and is located correspondingly to the light source (40), and the metallic layer is provided so as to turn the ineffective light into effective light, so that the light emitted at different angles from the light source (40) are fully utilized to improve the luminescent efficiency of the light source.

## Description

### BACKGROUND OF THE INVENTION

### Field of the Invention

The present invention relates to a package structure for a light source, and more particularly to a package structure for a high-luminance light source which makes full use of the light emitted from the light source at different angles.

### Description of the Prior Art

Nowadays, conventional illumination lamps still have many disadvantages, for example, although incandescent lamps are cheap, they have the disadvantages of low luminescent efficiency, high electricity consumption, short life and are fragile. And fluorescent lamps can save energy, but the wasted fluorescent lamps have the problem of mercury pollution and are fragile.

Relatively, the products of LED and cold light source which comply with the standard of energy saving and environment protection of various countries have the advantages of long life, low electricity consumption, pure light color, high shock resistance, miniaturization and are less likely to be broken.

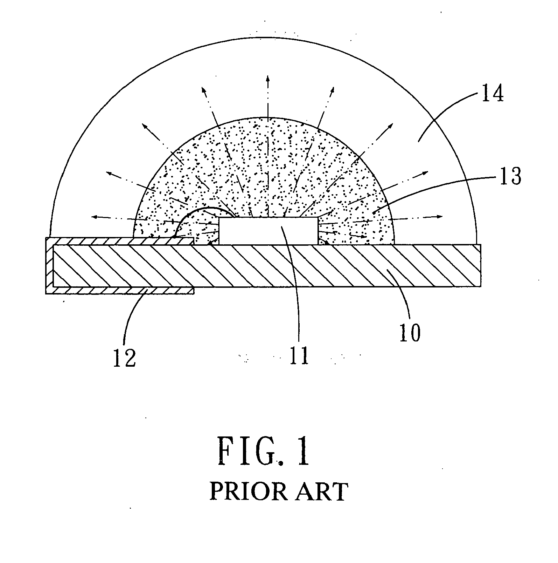

However, with the restriction of luminescent efficiency and the direction of the light, the above-mentioned products of LED and cold light source are still limited. With reference to Fig. 1, the products with LED light source have the following problems:
Firstly, a plurality of light emitting chips 11 is disposed on a circuit board 10 with a conductive layer 12, each light emitting chip 11 emits light in all directions and angles, and since the light emitted in the direction of the circuit board 10 by the light emitting chip 11 is ineffective, the luminescent efficiency (the effective rate of the emitted light) of the conventional LED and cold light source are too low. Such a design still can produce a luminance similar to the conventional bulbs, but it will waste a lot of energy. Thereby, finding a product with a high luminescent efficiency has become an important issue for the manufacturers and researchers.
Secondly, the conventional circuit board 10 usually uses a resin coating 13 to position and protect the light emitting chip 11, and a lens 14 is used to refract light. In addition, if the circuit board 10 is not defined with grooves or coatings to restrict the resin coating, the range of the resin coating 13 is difficult to control, and the cost of manufacturing such grooves or coatings is high.

The present invention has arisen to mitigate and/or obviate the afore-described disadvantages.

### SUMMARY OF THE INVENTION

The primary objective of the present invention is to provide a package structure for a high-luminance light source which uses the light emitted from the light source sufficiently.

To achieve the object of the present invention, a light refractive layer is formed on a surface of a circuit board and is located correspondingly to the light source, and the light refractive layer is provided for refracting the ineffective light of the light source, so as to turn the ineffective light into effective light, so that the light emitted at different angles from the light source are fully utilized to improve the luminescent efficiency of the light source.

The second objective of the present invention is to provide a package structure for a high-luminance light source which has high refractive and thermal conductive effects.

To achieve the object of the present invention, the package structure for a high-luminance light source of the present invention comprises a circuit board, at least one light source and a resin coating covering the light source. The circuit board is made of high thermal conductive ceramic porous material, and the surface of the light refractive layer of the circuit board is formed with a smooth metal mirror, so as to improve the effect of refraction.

The further objective of the present invention is to provide a package structure for a high-luminance light source which can restrict the range of the resin coating synchronously.

To achieve the object of the present invention, the light refractive layer of the present invention is a metallic layer protrusively formed on the surface of the circuit board by metal sputtering, and the light refractive layer can utilizes a stopping portion to restrict the range of the resin coating, so as to simplify the process of manufacturing and to reduce the cost.

It is to be noted that the light refractive layer with a smooth metal mirror of the present invention is formed by metal sputtering, electroplating or surface depositing, and the light refractive layer can be formed with a inclined light-guiding surface or an arc-shaped light-guiding surface correspondingly to the light source, so as to improve the luminescent efficiency of the present invention.

The present invention will become more obvious from the following description when taken in connection with the accompanying drawings, which show, for purpose of illustrations only, the preferred embodiments in accordance with the present invention.

### BRIEF DESCRIPTION OF THE DRAWINGS

Fig. 1 is a perspective view of a conventional package structure for a light source;
Fig. 2 is a perspective view of a circuit board and a light source in accordance with the present invention;
Fig. 3 is an assembly cross sectional view of the package structure for a high-luminance light source in accordance with the present invention;
Fig. 4 is an illustrative view of showing the refraction of the light source;
Fig. 5 is another illustrative view of showing a lens of the package structure for a high-luminance light source in accordance with the present invention; and
Fig. 6 is a further illustrative view of a diffusion layer in accordance with the present invention, wherein the lens is replaced by the diffusion layer.

### DETAILED DESCRIPTION OF THE PREFERRED EMBODIMENTS

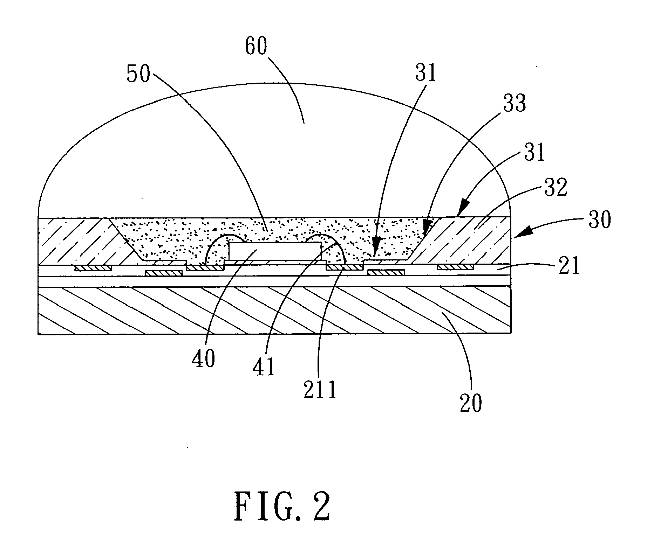

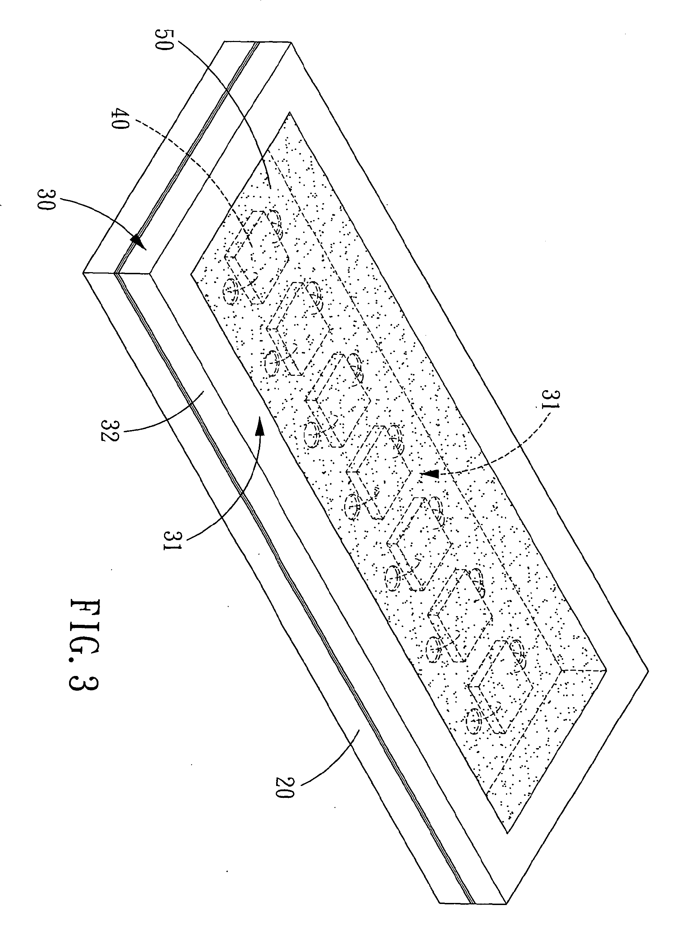

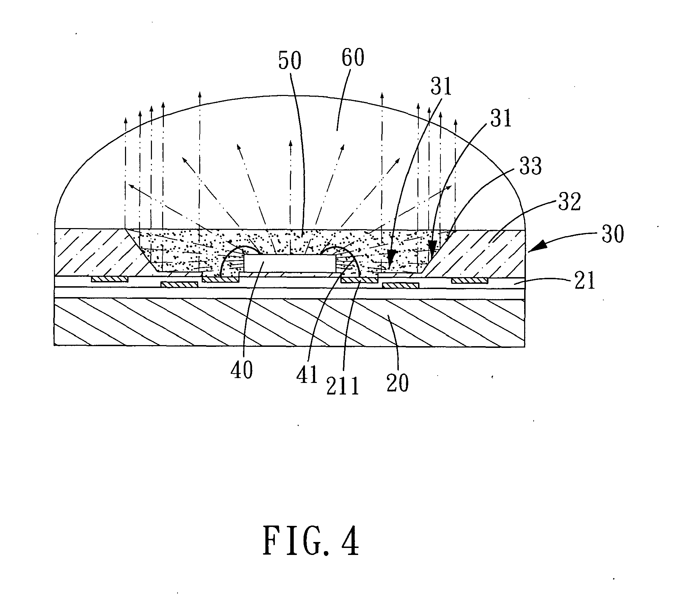

Referring to Figs. 2-4, a package structure for a high-luminance light source in accordance with the present invention comprises a circuit board 20, a light refractive layer 30, at least one light source 40, a resin coating 50 covering the light source 40, and a lens 60.

The circuit board 20 is formed with a printed circuit layer 21 with an electrode pad 211.

The light refractive layer 30 is a metallic layer protrusively formed on the surface of the circuit board 20 by the technique of metal sputtering, and the surface of the light refractive layer 30 is formed with a metal mirror 31. In addition, the sputtered light refractive layer 30 is protrusively formed with a stopping portion 32 located correspondingly to the electrode pad 211 of the circuit board 20, and the stopping portion 32 is formed with an inclined light-guiding surface 33 in the direction of the electrode pad 211.

The light source 40 is a light emitting chip and is located at the light refractive layer 30. The light source 40 is fixed correspondingly to the electrode pad 211 of the circuit board 20 and is electrically connected to the electrode pad 211 of the circuit board 20 by a bonding wire 41.

The resin coating 50 covers the light source 40 and the bonding wire 41 and is restricted in the stopping portion 32 protrusively formed on the light refractive layer 30.

The lens 60 covers the resin coating 50 and is provided for refracting the light emitted from the light source 40 effectively.

For a better understanding of the present invention, its operations and functions, reference should be made to Figs. 2-4 again:
When in use, since the light refractive layer 30 is formed on the surface of the circuit board 20, the surface of the light refractive layer 30 is formed with a metal mirror 31, and the stopping portion 32 is formed with an inclined light-guiding surface 33 in the direction of the electrode pad 211, when the light source 40 is activated to emit light, the light will be emitted through the resin coating 50 and the lens 60. Thereby, the present invention has the same luminescent efficiency as the conventional structure.

The key point is that the light emitted from the light source 40 in the direction of the light refractive layer 30 will be refracted by the metal mirror 31 of the light refractive layer 30, and the transverse light will be refracted by the inclined light-guiding surface 33 of the stopping portion 32. Thereby, the present invention can effectively refract the light of the light source 40 in all directions, so as to produce a better luminescent efficiency than the conventional structure.

Moreover, the circuit board 20 of the present invention is made of high thermal conductive ceramic porous material, so that chips of the light source 40 can be cooled effectively.

In addition, since the stopping portion 32 and the light refractive layer 30 can restrict the range of the resin coating 50 synchronously, the light refractive layer 30 of the present invention formed by metal sputtering, electroplating or surface depositing not only can produce a high luminescent efficiency, but also it can utilizes the stopping portion 32 to restrict the range of the resin coating 50, so as to simplify the process of manufacturing and to reduce the cost.

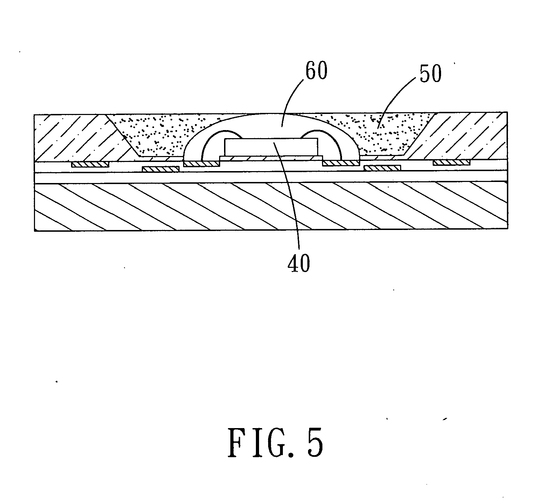

With reference to Fig. 5, the lens 60 of the present invention can be located in the resin coating 50, and such an arrangement can also effectively refract the light emitted from the light source 40.

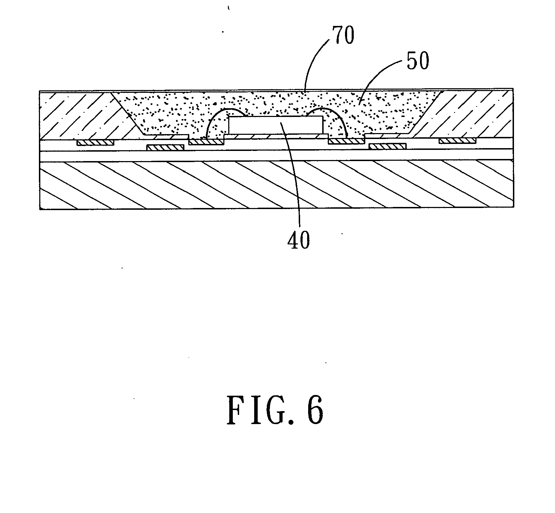

With reference to Fig. 6, the lens 60 is replaced by a diffusion layer 70 which also covers the resin coating 50. With a fog surface structure, the diffusion layer 70 can diffuse the light emitted from the light source 40 effectively and evenly, and the diffusion layer 70 is formed by the methods of diffuser-coating and dispersing agent-coating.

In a word, the present invention is characterized in that:
Firstly, the light refractive layer is formed on the surface of the circuit board and is located correspondingly to the light source, the light refractive layer is provided for refracting the ineffective light of the light source, so as to turn the ineffective light into effective light, so that the light emitted at different angles from the light source are fully utilized to improve the luminescent efficiency of the light source.
Secondly, the circuit board of the present invention is made of high thermal conductive ceramic porous material, and the surface of the light refractive layer of the circuit board is formed with a metal mirror, so as to increase the refractive effect.
Thirdly, the stopping portion and the light refractive layer of the present invention can restrict the range of the resin coating synchronously, and such an arrangement can simplify the structure and reduce the cost of the present invention effectively.

To summarize, a package structure for a high-luminance light source in accordance with the present invention comprises a circuit board, at least one light source and a resin coating covering the light source and is characterized in that: the light refractive layer is formed on the surface of the circuit board and is located correspondingly to the light source, and the light refractive layer not only can refract the ineffective light of the light source, so as to turn the ineffective light into effective light, but also can restrict the range of the resin coating, so that the light emitted at different angles from the light source are fully utilized to improve the luminescent efficiency of the light source.

While we have shown and described various embodiments in accordance with the present invention, it should be clear to those skilled in the art that further embodiments may be made without departing from the scope of the present invention.

## Claims

1. A package structure for a high-luminance light source comprising: a circuit board, a light refractive layer, at least one light source and a resin coating covers the light source, wherein:
the light refractive layer is formed on a surface of the circuit board;
the light source is mounted on the circuit board, light emitted from the light source are effectively refracted by the light refractive layer; and
the resin coating is provided for covering the light source.

2. The package structure for a high-luminance light source as claimed in claim 1 further comprising a lens, wherein:
the circuit board is disposed with a printed circuit layer with an electrode pad;
the light refractive layer is a metallic layer formed with a metal mirror on a surface thereof, the light refractive layer is protrusively formed with a stopping portion located correspondingly to the electrode pad of the circuit board;
the light source is a light emitting chip and is located at the light refractive layer, the light source is fixed correspondingly to the electrode pad of the circuit board and is electrically connected to the electrode pad of the circuit board by a bonding wire;
the resin coating is provided for covering the light source and the bonding wire and is restricted in the stopping portion of the light refractive layer; and
the lens is located outside the light source and the bonding wire and is provided for covering the resin coating, so as to effectively refract the light emitted from the light source.

3. The package structure for a high-luminance light source as claimed in claim 2, wherein the stopping portion of the light refractive layer is formed with an inclined light-guiding surface in a direction of the electrode pad.

4. The package structure for a high-luminance light source as claimed in claim 2, wherein the stopping portion of the light refractive layer is formed with an arc-shaped light guiding surface in a direction of the electrode pad.

5. The package structure for a high-luminance light source as claimed in claim 1, wherein the light refractive layer is formed on the surface of the circuit board by metal sputtering, electroplating and surface depositing.

6. The package structure for a high-luminance light source as claimed in claim 1, wherein the circuit board is made of ceramic porous material.

7. The package structure for a high-luminance light source as claimed in claim 1 further comprising a diffusion layer, wherein:
the circuit board is disposed with a printed circuit layer with an electrode pad;
the light refractive layer is a metallic layer formed with a metal mirror on the surface thereof, the light refractive layer is protrusively formed with a stopping portion located correspondingly to the electrode pad of the circuit board;
the light source is a light emitting chip and is located at the light refractive layer, the light source is fixed correspondingly to the electrode pad of the circuit board and is electrically connected to the electrode pad of the circuit board by a bonding wire;
the resin coating is provided for covering the light source and the bonding wire and is restricted in the stopping portion of the light refractive layer;
and the diffusion layer covers the resin coating, and with a fog surface structure, the diffusion layer is provided for diffusing the light emitted from the light source effectively and evenly.

8. The package structure for a high-luminance light source as claimed in claim 7, wherein the diffusion layer is formed by diffuser-coating and dispersing agent-coating.

9. The package structure for a high-luminance light source as claimed in claim 7, wherein the stopping portion of the light refractive layer is formed with an inclined light-guiding surface in the direction of the electrode pad.

10. The package structure for a high-luminance light source as claimed in claim 7, wherein the stopping portion of the light refractive layer is formed with an arc-shaped light-guiding surface in a direction of the electrode pad.
